# EUROPEAN PATENT APPLICATION

(11) **EP 2 560 467 A1**
(43) Date of publication of application: **20.02.2013**
(21) Application number: 12177850.0
(22) Date of filing: 25.07.2012
(51) Int. Cl.: H05K 1/18, H05K 1/11, H05K 1/14, H05K 3/36

(54) **Method for mounting a component to an electric circuit board, electric circuit board and electric circuit board arrangement**

(30) Priority: 18.08.2011 US 201161524774 P
(71) Applicant: BIOTRONIK SE & Co. KG, 12359 Berlin (DE)
(72) Inventor: Primavera, Anthony A., Newberg, OR Oregon 97132 (US)
(74) Representative: Lindner-Vogt, Karin L.

(57) **Abstract**

The invention pertains to a method for mounting a component (50) to an electric circuit board (10), comprising the steps:
- providing at least one cavity (40) in the electric circuit board (10, 100);
- arranging the component (50) in the cavity (40);
- generating in the at least one cavity (40) mechanical and/or electrical connections simultaneously to at least two locations of the component (50).

The invention also pertains to a method for making an electric circuit board arrangement (200) comprising at least one electric circuit board (300, 400, 500), comprising the steps:
- providing at least one cavity (340, 440, 540) and/or through-hole (320, 420, 520) in the at least one electric circuit board (300, 400, 500);
- arranging the component (50) in the at least one cavity (340, 440) and/or in a through-hole (320, 420) being mechanically and/or electrically connectable by contact in the at least one cavity (340, 440) and/or through-hole (320, 420) and
- stacking one or more electric circuit boards (400, 500) on top of the at least one electric circuit board (300) and coupling the electric circuit boards (300, 400, 500) by solderable terminal pads (52, 54) of the component (50).

## Description

The invention pertains to the art of electronic devices and, more specifically, to a method for mounting electronic components to a circuit board, an electric circuit board and an electric circuit board arrangement.

During assembly of electronic devices components need to be interconnected to the circuit board and other components. Some components such as leaded devices are placed onto the top of a circuit board pad and soldered to the substrate in reflow soldering. Other components such as integrated circuits (ICs) are often wire bonded to a substrate. Many ICs and semiconductors require both active side and passive side connectivity. The bottom side of the device is often a ground connection or common node. In these cases, the assembly process can be complex since two sides of the component, e.g. top and bottom, need to be attached to the substrate.

Currently, wire bonding and ultrasonic ribbon bonding are used to attach active side terminals to a substrate while simultaneously needing a conductive adhesive or soldering process for common node or ground connections. Flip chip and direct chip attach processes would use sequential soldering processes for both top and bottom side nodes.

Current methods require multiple manufacturing sequences to interconnect the top and bottom sides of the component. The required board real estate is large since wire bonds need encapsulated or overmolded post assembly. The known multi step soldering processes are time consuming and require complex structures to connect top and bottom sides of the die to the substrate.

Current approaches require that each side or edge of a die be connected at different steps in the assembly process. For example, a die with a back side ground first requires a conductive material such as silver filled epoxy be placed on a substrate and the die placed onto the epoxy and cured. The top side connections are then made in a series of other assembly steps such as wire bonding. Finally, the assembly is encapsulated to protect the wire bonds.

It is an object of the invention to provide a method for mounting a component to an electric circuit board which particularly allows for an attachment of top and bottom of the component.

A further object is to provide an electric circuit board comprising a component, particularly with top and bottom end of the component attached to the electric circuit board.

A further object is to provide an electric circuit board arrangement comprising a plurality of electric circuit boards and at least one component, particularly with top and bottom end of the component attached to an electric circuit board.

The objects are achieved by the features of the independent claims. The other claims, the description and the drawing include favourable embodiments of the invention.

A method for mounting a component an electric circuit board is proposed wherein the method comprises the steps:
- providing at least one cavity in the electric circuit board;
- arranging the component in the cavity;
- generating in the at least one cavity mechanical and/or electrical connections simultaneously to at least two surfaces of the component.

The cavity may be a pocket extending partially in the electric circuit board or may be a through-hole extending from top to bottom surface of the electric circuit board.

The proposed method is particularly useful in surface mount technologies (SMT) where components, particularly electric components, are mounted to an electric circuit board. During SMT assembly, components need to be interconnected to the circuit board and other components. Traditionally, multilayer circuit boards are formed in which layer to layer connections are created by metalized vias and copper plating. Components such as discrete capacitors and the like are assembled to the top and bottom of the electric circuit board by soldering processes.

Advantageously, the invention allows for the simultaneous interconnection of two sided or top and bottom metalized components, such as a die. In addition, the component may be placed in such a way that allows for a three dimensional use of the electric circuit board and space above the component. The inventive method replaces complex and expensive multiple sequential interconnections for top and bottom metal components. The invention removes the need to sequential assembly steps when connect front and back side metalized components (such as a die) to a substrate (such as an electric circuit board).

The component may be an electric device having an end and side terminal, such as chip resistors and capacitors and the like. The component's terminals can be electrically connected to the electric circuit board in one process step. Alternatively, the component may be a device without external terminals, for instance an inductance such as an RFID transponder or the like.

In conventional electric circuit boards, the required board real estate made by conventional methods is larger than in the proposed method since conventional wire bonds require encapsulated or overmolded post assembly. Multi step soldering processes are time consuming and require complex structures to connect top and bottom sides of the component to the electric circuit board..

The proposed method allows for simplification of processes, simultaneous bulk or mass assembly, top and bottom side soldering of two sided die components, use of the space above the embedded component for other assemblies, miniaturization, low cost assembly methods as well as high yield and reliable processes.

According to a favourable development, the method may further comprise the step of arranging the cavity adjacent at least one through-hole or via in the electric circuit board. Advantageously, the method may further comprise the step of providing the at least one through-hole or via with an electrical conducting plating and connecting the component mechanically and/or electrically to the plating. Favourably, the metallic plating of the through-hole or via can be used as electrical connection for connecting the terminals of the component to one or more electric contact pads of the electric circuit board. The through-hole penetrates the electric circuit board so that electrical connections to the component can be provided at the top as well as at the bottom surface of the electric circuit board. Alternatively, a via is a blind hole so that electric electrical connections to the component can be provided at the surface of the electric circuit board from where the via is accessible..

According to a favourable development, the method may further comprise the step of coupling the component to the at least one circuit board by at least one of reflow soldering, solder wave, selective solder, solder fountain. Advantageously, simultaneous bulk or mass assembly, and particularly top and bottom side soldering of two sided die components can performed.

According to a favourable development, the method may further comprise the step of arranging the component flush with at least one surface of the at least one electric circuit board or flush with a surface of a plating arranged at the at least one electric circuit board. Expediently, the space above the embedded component can be used for other assemblies. This allows for reduction of the required real estate of the electric circuit board.

According to another aspect of the invention, an electric circuit board is proposed, the electric circuit board comprising
- at least one cavity in the electric circuit board;
- at least one component arranged in the at least one cavity;
- mechanical and/or electrical contacts to the component in the at least one cavity generated simultaneously to at least two surfaces of the component.

It is of advantage that a compact device can be provided which allows for miniaturization of the device. Electrical connections can be established in one process step.

The cavity may be a pocket extending partially in the electric circuit board or may be a through-hole extending from top to bottom surface of the electric circuit board.

According to a favourable embodiment, the at least one component may be an electric device, particularly a device with top and bottom and/or side terminals. Electric connections to the component's terminals can be established by using metallic plating of through-holed and/or vias in the electric circuit board. Particularly, the cavity may be arranged adjacent one or more through-holes or vias. Expediently, the number of through-holes corresponds to the number of terminals of the component.

According to a favourable embodiment, the at least one component may be arranged flush with respect to a surface of the electric circuit board or may be arranged flush with respect to a surface of a plating on the electric circuit board. The arrangement is compact, as the space over the component may be used for arranging other components such as electrical components at the surface of the electric circuit board.

According to another aspect of the invention a method for making an electric circuit board arrangement is proposed, comprising the steps:
- providing at least one cavity in the at least one electric circuit board;
- arranging the component in the at least one cavity being mechanically and/or electrically connectable by contacts in the at least one cavity; and
- stacking one or more electric circuit boards on top of the at least one electric circuit board and coupling the electric circuit boards by solderable terminal pads of the component.

During SMT assembly, components need to be interconnected to the circuit board and other components. Traditionally, multilayer circuit boards are formed in which layer to layer connections are created by metalized vias and copper plating. Components such as discrete capacitors are assembled to the top and bottom of the circuit board by soldering processes. This invention uses the concept of stacking individual circuit boards on top of each other, and creating interconnects by soldering aligned features on each board. In particular, this invention uses components embedded in the electric circuit boards to allow adjoined stacking of electric circuit boards. Stacked electric circuit boards allow unique three dimensional circuit configurations and provide higher assembly density and shape conformity than traditional SMT products.

This invention provides a method for the simultaneous interconnection of two or more independent circuit boards. This allows high component density and effective use of volume within unconventional three dimensional shapes. It removes post SMT processes needed in standards three dimensional PCB methods (PCB= Printed Circuit Board), such as folding. The use of rigid materials fastened together in multiple layers provides increased robustness. This method replaces multiple sequential interconnections for top and bottom metal components.

Currently, multilayer circuit boards are formed by traditional drill and plating of vias and through-holes to connect layers and surface mounting components on the top and bottom of the PCB. Embedding components inside PCBs is being done at board manufactures however, it is an expensive and complicated process and the components cannot be changed or repaired once the board is laminated. This invention allows for the use of lower cost high density circuit layer and uses an inexpensive and simple approach to embed components in the boards. Current methods for utilizing volume within three dimensional shapes involve folding flexible PCB material, which requires complicated process steps, are more difficult and expensive to manufacture.

Particularly, current methods require multiple manufacturing sequences to interconnect the top and bottom sides of the component. Multi step soldering processes are time consuming and require complex structures to connect top and bottom sides of the die to the substrate.

Current approaches require components to be placed into the laminated structure of the electric circuit board during PCB manufacturing. This can potentially lead to component damage as lamination press temperatures and pressured are high. In addition, once the components are embedded in the laminate, they cannot be changed, reworked or probe tested directly. This invention describes an alternative method for embedding components by using a stacked board structure and standard assembly processes.

This invention allows for simplification of processes for embedding components, simultaneous bulk or mass assembly of two circuit boards, top and bottom side soldering of two sided die, use of the space inside a board to embed components, miniaturization, low cost assembly methods, and ability to utilize unconventional volume shapes.

According to a favourable development, the method further comprises arranging the cavity adjacent at least one through-hole or via in the electric circuit board. A compact arrangement is achieved. Use can be made of existing electrical connections. Electric connections to the component's terminals can be established by using metallic plating of through-holed and/or vias in the electric circuit board. Particularly, the cavity may be arranged adjacent one or more through-holes or vias. Expediently, the number of through-holes corresponds to the number of terminals of the component.

According to a favourable development, the method further comprises providing the at least one through-hole or via with an electrical conducting plating and connecting the component mechanically and/or electrically to the plating. A compact arrangement is achieved. Use can be made of existing electrical connections.

According to a favourable development, the method further comprises coupling the component to the circuit board by at least one of reflow soldering, solder wave, selective solder, solder fountain. Low cost assembly methods can be used.

According to a favourable development, the method further comprises interconnecting the electric circuit boards by reflow soldering. Simultaneous bulk or mass assembly of two or more circuit boards and low cost assembly methods can be used.

According to another aspect of the invention, an electric circuit board arrangement is proposed, comprising at least one electric circuit board which comprises
- at least one cavity in the at least one electric circuit board;
- at least one component arranged in the at least one cavity being mechanically and/or electrically connectable by contacts in the at least one cavity; and
- one or more electric circuit boards stacked on top of the at least one electric circuit board and coupled with adjacent electric circuit boards by solderable connections.

This invention allows for simplification of processes for embedding components, simultaneous bulk or mass assembly of two circuit boards, top and bottom side soldering of two sided die, use of the space inside a board to embed components, miniaturization, low cost assembly methods, and ability to utilize unconventional volume shapes.

The cavity may be a pocket extending partially in the electric circuit board or may be a through-hole extending from top to bottom surface of the electric circuit board.

According to a favourable development, the one or more electric circuit boards may be coupled by solderable terminations of the component. A very compact design is achieved as well as simultaneous bulk or mass assembly of two or more circuit boards.

According to a favourable development, edges of the electric circuit boards may be arranged in a staggered arrangement. The stack of electric circuit boards can have unusual or unconventional volume shapes.

The present invention together with the above-mentioned and other objects and advantages may best be understood from the following detailed description of the embodiments, but not restricted to the embodiments, wherein is shown in:
- Fig. 1: an example embodiment of an electric circuit board in surface mount technology before mounting of a component;
- Fig. 2a, 2b: in side cut views method steps of preparing a cavity in an electric circuit board of Fig. 1;
- Fig. 3a-3d: in side cut views several method steps of mounting and connecting a component in an electric circuit board of Fig. 2;
- Fig. 4: an alternative connection of a component in a cavity;
- Fig. 5a-5d: in top views a cavity adjacent three through-holes (Fig. 5a), a component mounted in the cavity (Fig. 5c), and a side cut view of the arrangement (Fig. 5c) and a top view of an alternative arrangement of the component in the cavity (Fig. 5d);
- Fig. 6a, 6b: in side cut views conventional surface mount components (Fig. 6a), and an example embodiment of the invention;
- Fig. 7: in a side cut view an example embodiment three stacked electric circuit boards according to the invention;
- Fig. 8: an example embodiment of the invention showing two separated electric circuit boards before assembly;
- Fig. 9a-9c: example embodiments of interconnected electric circuit boards;
- Fig. 10a, 10b: in a side cut view and a perspective view stacked electric circuit boards with staggered edges.

In the drawings, like elements are referred to with equal reference numerals. The drawings are merely schematic representations, not intended to portray specific parameters of the invention. Moreover, the drawings are intended to depict only typical embodiments of the invention and therefore should not be considered as limiting the scope of the invention.

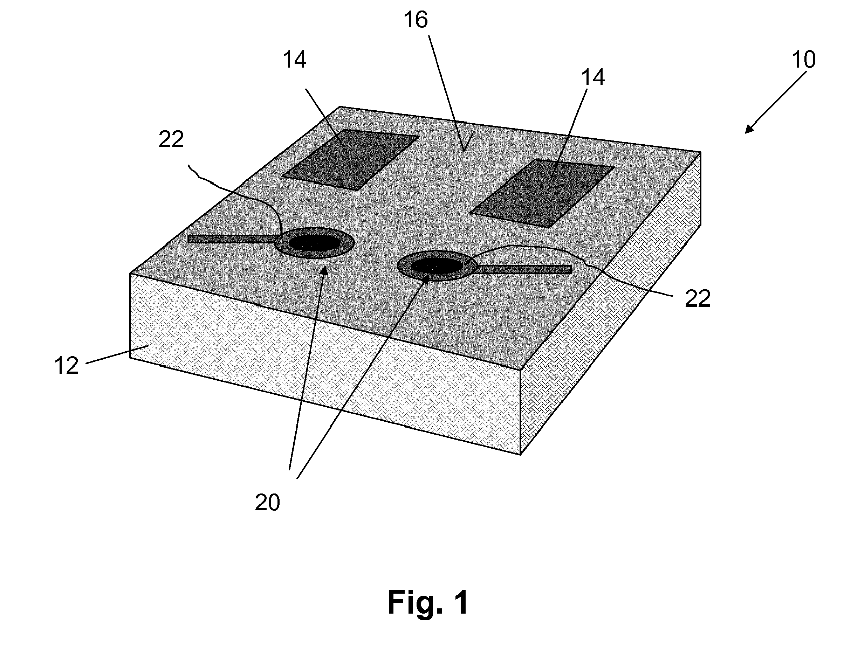

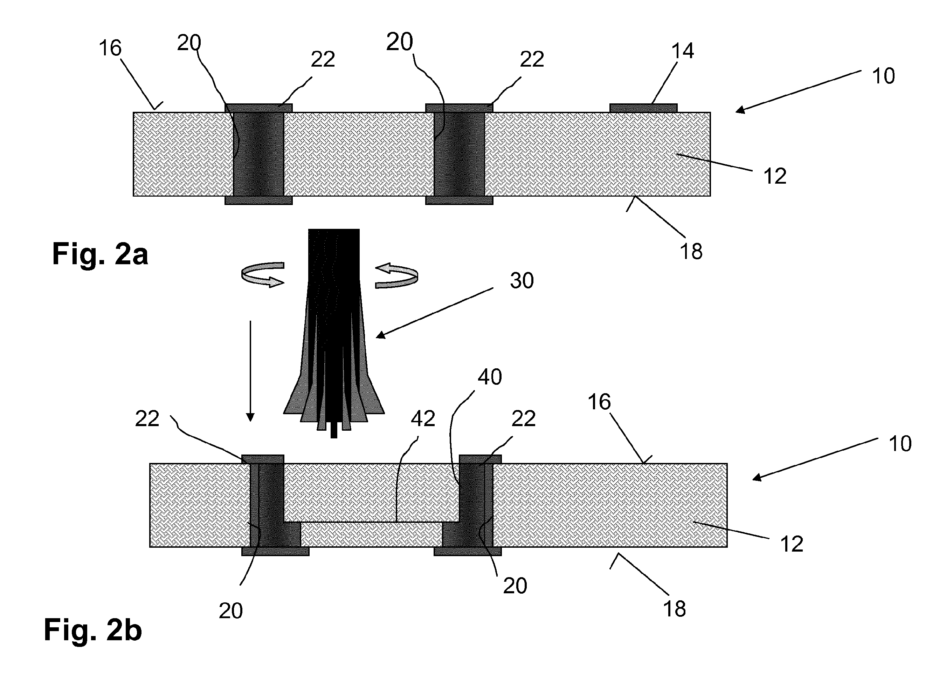

Figure 1 depicts an example embodiment an example embodiment of an SMT electric circuit board 10 before mounting of a component and Figures 2a, 2b illustrate method steps of preparing a cavity 40 in the electric circuit board 10 of Figure 1.

On a top surface 16 of the electric circuit board 10 two parallel through-holes 20 extending through body 12 of the electric circuit board 10 are arranged which are equipped with metallic platings 22 inside the through-holes 20 and on top of surface 16 as well as on the opposite back surface 18. By way of example, terminals 14 are arranged for placing and soldering electric components to surface 16 of the electric circuit board 10. The through-holes 20 can be pin through-holes, for instance, which are provided for mounting pins of leaded components to the electric circuit board 10.

The inventive method involves creating a cavity 40 in the electric circuit board 10 by a tool 30 such as an ablation or mechanical tool, e.g. a mill. The cavity 40 forms a pocket having a bottom 42 in body 12 of the electric circuit board 10 and is created between two or more adjacent plated through-holes 20 in the electric circuit board 10.

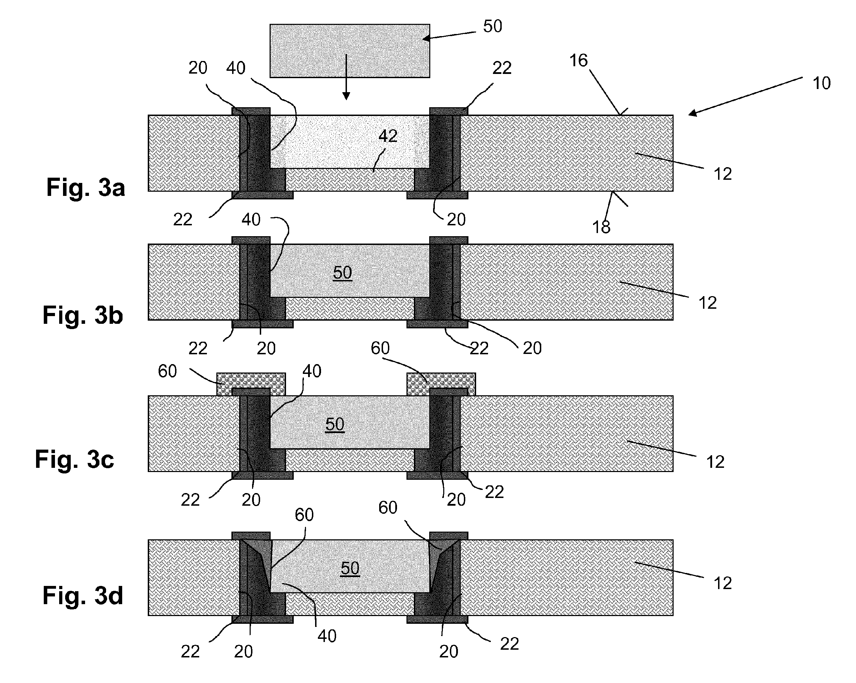

A component 50 is then placed into the cavity 40 (see Figures 3a to 3d) and soldered or attached using conductive adhesive. Figures 3a-3d illustrate the placement of the component 50 in side cut views several method steps of mounting and connecting the component 50 in the cavity 40 of the electric circuit board 10.

The cavity 40 becomes a mechanical resting place or placeholder for the component 50 during soldering. The component 50 may be placed into the cavity 40 by an automated process or by hand. The attachment process for terminals (not shown) on the component 50 can be created by a variety of methods, including wave or bulk solder processes, printed solder or by using conductive adhesive.

Cavity 40 forms a pocket which is deep enough to accommodate the component 50 so that the component 50 is flush with top surface 16 of the electric circuit board 10 (Figures 3a, 3b).

A solder print process can accomplish the electric connection between component 50 and the plating 22 of the through-holes 20. Alternatively, the solder 60 can be dispensed on the respective regions. The component 50 is placed into the cavity 40 and then the electric circuit board 10 is printed by traditional stencil or screen printing to deposit solder paste onto the terminal/plated through-hole regions (Figure 3c).

A subsequent reflow process will cause the solder 60 to spread into the trough-holes 20 and onto attachment pads of component 50 (Figure 3d). Conductive adhesive could alternatively be applied to the plated through-hole/termination regions.

Reflow soldering is a process in which the solder paste 60, typically a sticky mixture of powdered solder and flux is used to temporarily attach one or several electrical components to their contact pads, after which the entire assembly is subjected to controlled heat, which melts the solder, permanently connecting the electric joint. Heating may be accomplished by passing the assembly through a reflow oven or under an infrared lamp or by soldering individual joints with a hot air pencil or the like.

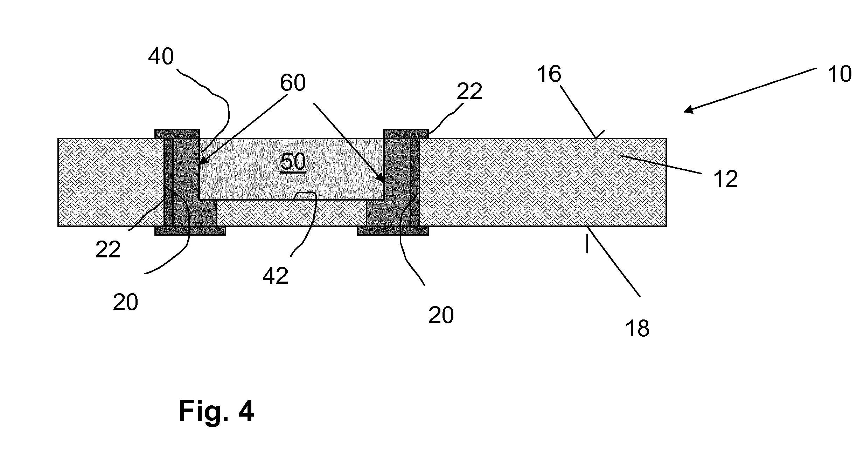

For a simple approach, the component 50 once placed into the cavity 40 may be passed over a molten wave or selective solder wave. The solder 60 wets the plating 22 of the through-holes 20 and moves into gaps between component 50 and adjacent plating 22 and reacts with and attaches to terminal pads (not shown in the Figure) of component 50 that are adjacent to the plated through-holes 20. Surface tension and capillary flow pulls the solder 60 into the through-holes 20 and the solder wetting force allows the solder 60 to flow onto the metal plating 22 to the component 50 as indicated in Figure 4.

The wave approach may require the use of a non-conductive adhesive to prevent the component from falling out of the pocket during soldering. A reflow retaining fixture could also be used to retain component 50 in the cavity 40 during soldering.

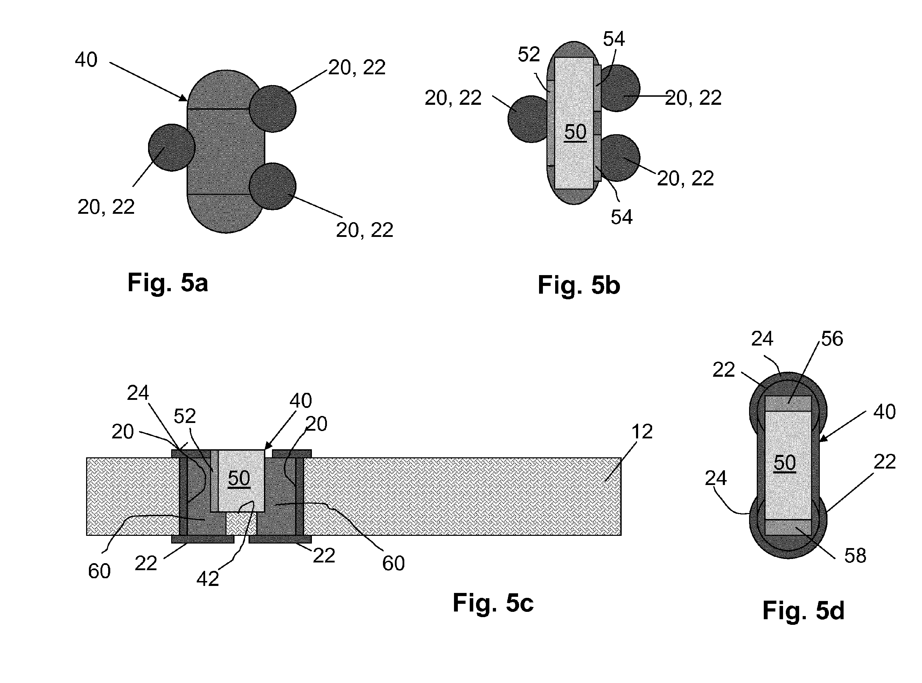

Figures 5a-5c depict in top views a cavity 40 adjacent three through-holes 20 (Figure 5a), and a component 50 mounted in the cavity 40 (Figure 5b). Figure 5c shows a side cut view of the arrangement with component 50 placed on edge in the cavity 40. Figure 5d shows an alternative arrangement of a component 50 in cavity 40.

The component 50 has a terminal pad 52 on one main surface and two terminals 54 on the opposite main surface. By placing component 50 on edge in the cavity the terminals 52, 54 are aligned with the respective through-holes 20 on each side of component 50 (one adjacent to terminal 52 and one adjacent to each of terminals 54). Component 50 is accommodated in the cavity 40 so that one side surface is flush with surface 24 of the plating 22 of the through holes 20.

In Figure 5d, component 50 has a terminal pad 56, 58 on opposing narrow sides of component 50. The terminal pads 56, 58 align with two opposing through-holes 20 which can be pin through-holes 20 in the electric circuit board 10.

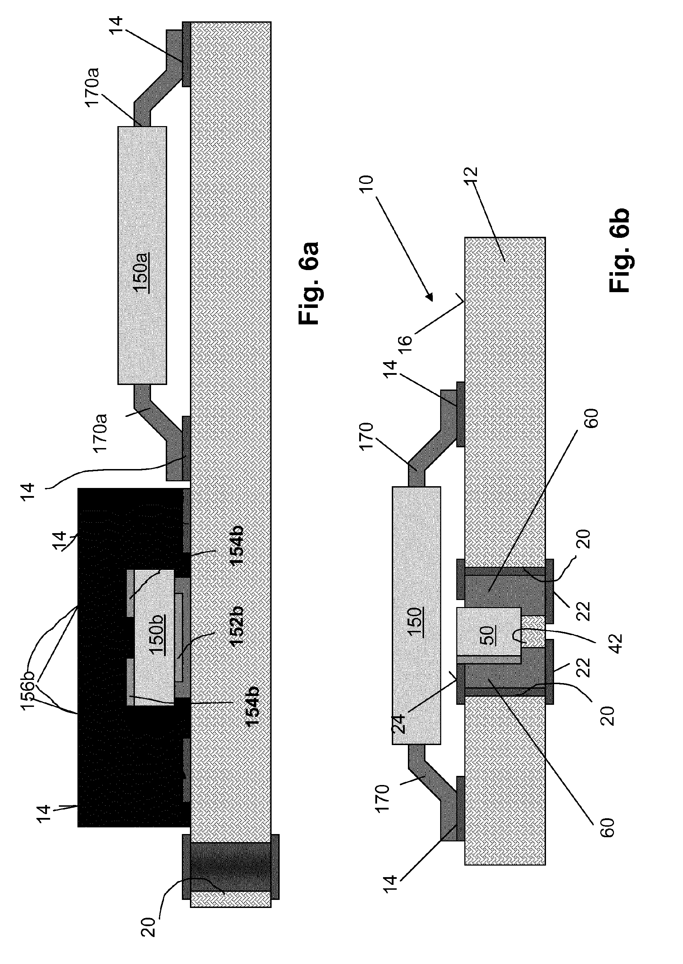

Figures 6a illustrates a side cut view of a conventional SMT circuit board where electric components 150a, 150b are placed at the surface of the electric circuit board. Component 150a is a leaded component with leads 170a attached to terminal pads 14 on the top surface of the electric circuit board. A traditional wire bond component 150b is arranged next to component 150a. Component 150b has a bottom terminal pad 152b and front terminal pads 154b. The bottom terminal 152b is soldered or glued to the top surface of the electric circuit board while wires 156a are attached to the front surface terminal pads 154. The wires 154b are soldered to terminal pads 14 arranged on the top surface of the electric circuit board.

Figure 6b shows an example embodiment of the invention. According to the invention, expensive real estate of electric circuit board 10 is saved by arranging a component 50 beneath the leaded component 150 in a cavity 40 provided in the body 12 of the electric circuit board 10. Terminal pads 52 and 54 on either side of component 50 are electrically connected to regions of plating 22 of through-holes 20 by solder 60. The space above component 50 is available for component 150 on top of the electric circuit board 10. Compared to a conventional arrangement as shown in Figure 6a, the inventive arrangement requires only about 50% of the real estate on the electric circuit board 10 by making use of the space above the embedded component 50 for other assemblies. This allows for miniaturization of complex electric devices.

To summarize, a simplification of the manufacturing process of the electric circuit board 10 can be achieved. The inventive method allows for simultaneous bulk or mass assembly. Top and bottom side soldering of two-sided dies can be achieved simultaneously. Low cost assembly methods and high yield and reliable processes can be employed to manufacture SMT devices.

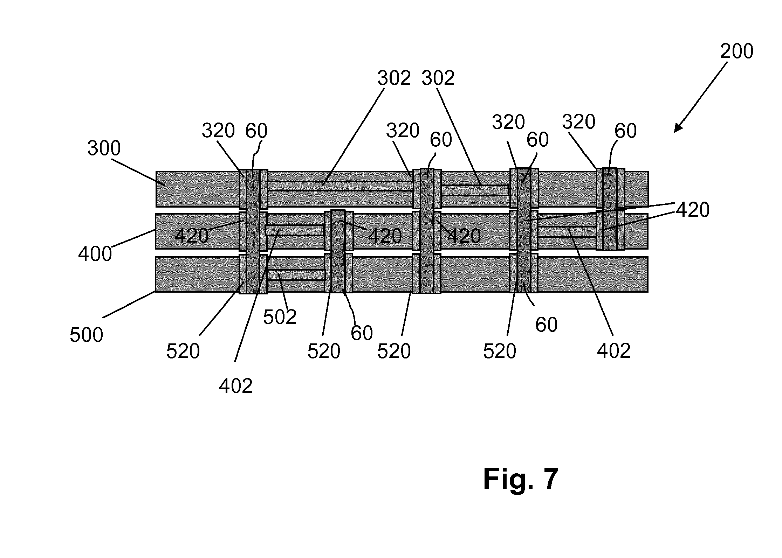

Figure 7 illustrates an embodiment of an electric circuit board arrangement 200 according to another aspect of the invention.

The electric circuit board arrangement 200 comprises a multitude of individual electric circuit boards 300, 400, 500 stacked on top of each other and electrically connected by way of through-hole soldering. Solder paste 60 is reflowed to create electrical connections between the individual electric circuit boards 300, 400, 500. Within the individual bodies of the electric circuit boards 300, 400, 500, some of the multiple through-holes 320, 420, 520 are interconnected by metallic paths 302, 402, 502.

During SMT assembly, components need to be interconnected to the electric circuit boards 300, 400, 400 and other components. Traditionally, multilayer circuit boards are formed in which layer to layer connections are created by metalized vias and copper plating. Components such as discrete capacitors, resistors or the like are assembled to the top and bottom of the circuit board by soldering processes. According to this aspect of the invention the individual electric circuit boards 300, 400, 500 are stacked on top of each other, and interconnects are created by soldering aligned features on each electric circuit board 300, 400, 500. Solder is indicated by reference numeral 60.

This invention uses the embedded component concept as described in the preceding embodiments to allow adjoined stacking of boards. The stacked electric circuit board arrangement 200 allows for unique three dimensional circuit configurations and provides higher assembly density and shape conformity than traditional SMT products.

The method according to this aspect of the invention allows for simultaneous interconnection of two or more independent electric circuit boards 300, 400, 500. This concept allows high component density and effective use of volume within unconventional three dimensional shapes. It removes post SMT processes needed in standards three dimensional PCB methods (PCB = printed circuit board), such as folding. The use of rigid materials for the individual electric circuit boards 300, 400, 500 fastened together in multiple layers provides increased robustness of the arrangement. The inventive method replaces multiple sequential interconnections for top and bottom metal components.

Currently, multilayer electric circuit boards are formed by traditional drill and plating of vias and holes to connect layers and surface mounting components on the top and bottom of the PCB. Embedding components inside PCBs is being done at board manufactures. However, it is an expensive and complicated process and the components cannot be changed or repaired once the PCB is laminated. This invention allows for the use of lower cost high density circuit layer and uses an inexpensive and simple method to embed components in the individual electric circuit boards. Current methods for utilizing volume within three dimensional shapes involve folding flexible PCB material, thus requiring complicated process steps, are more difficult and expensive to manufacture.

Current methods require multiple manufacturing sequences to interconnect the top and bottom sides of the component. Multi step soldering processes are time consuming and require complex structures to connect top and bottom sides of the die to the substrate.

Current approaches require components to be placed into the laminated structure of the board during PCB manufacturing. This can potentially lead to component damage as lamination press temperatures and pressures are high. In addition, once the components are embedded in the laminate, they cannot be changed, reworked or probe tested directly. The inventive method describes an alternative method for embedding components by using a stacked electric circuit board arrangement 200 and standard assembly processes.

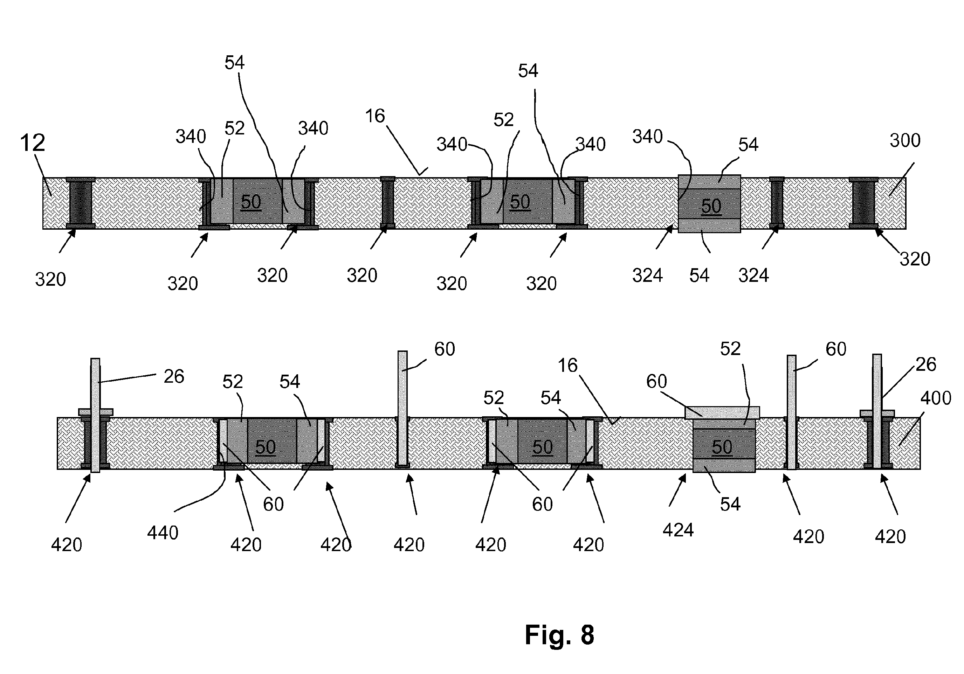

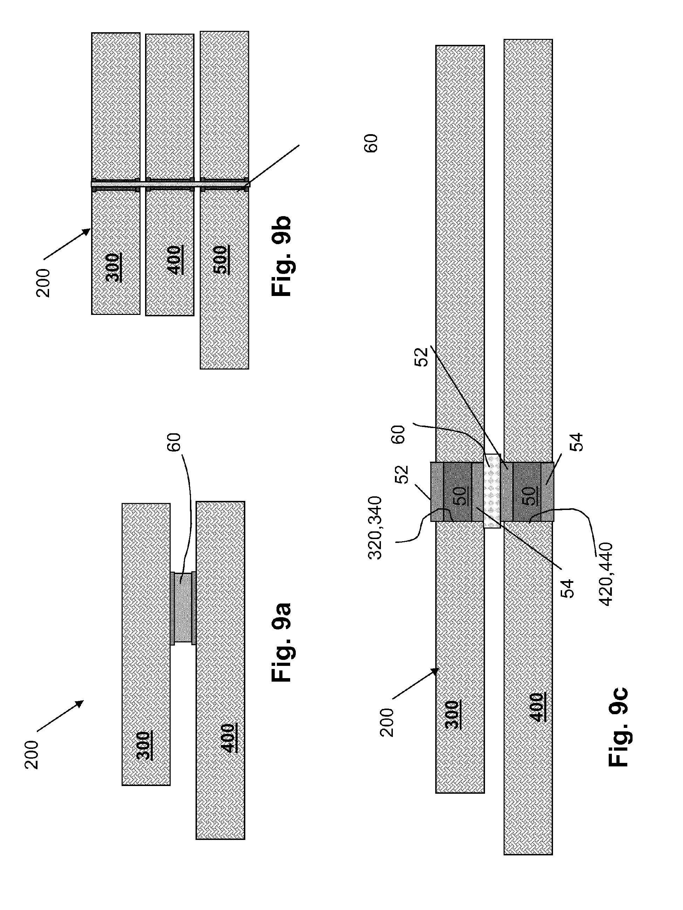

Figure 8 and Figures 9a to 9c depict example embodiments illustrating the inventive method. The method involves taking individual electric circuit boards 300, 400 that have cavities 340, 440 and/or large plated through-holes 320, 420 and placing components 50 with solderable terminal pads 52, 54 into the cavities 340, 440 or through-holes 320, 420. Once placed, solder paste 60 is applied to the terminal pads 52, 54 of the components 50 in one electric circuit board 300. Another (likewise assembled) electric circuit board 400 is placed on top of the first assembled electric circuit board 300 and then the structure undergoes a reflow solder process as indicated in Figures 9a-9c. Electric circuit board to electric circuit board interconnects can be achieved through a variety of methods, outlined in the attached material. For instance, pins 26 can be used to create electric connections but also maintain alignment and create a structure for a reflow process.

Electrical connections between the individual electric circuit boards 300, 400, 500 can be established for instance by a board-to-board connection tab (Figure 9a) and a direct connect through through-holes by solder 60 (Figure 9b). Components 50 can also be placed through the through-hole 320, 420 or cavity 340, 440 so that the component's terminal pads are accessible on each side of the electric circuit board (Figure 9c). Solder paste 60 allows for forming a connection by direct component-to component connection.

Alignment of the individual electric circuit boards 300, 400, 500 can be made by automated visual inspection or even by simple tooling pins 26, as shown in Figure 8. Expediently, multiple component types can be used in this inventive method, including most two terminal devices, die with front/back side terminations and other configurations.

The assembly of stacked electric circuit boards 300, 400, 500 is processed once in a reflow process, creating a high density, rigid three dimensional electric circuit.

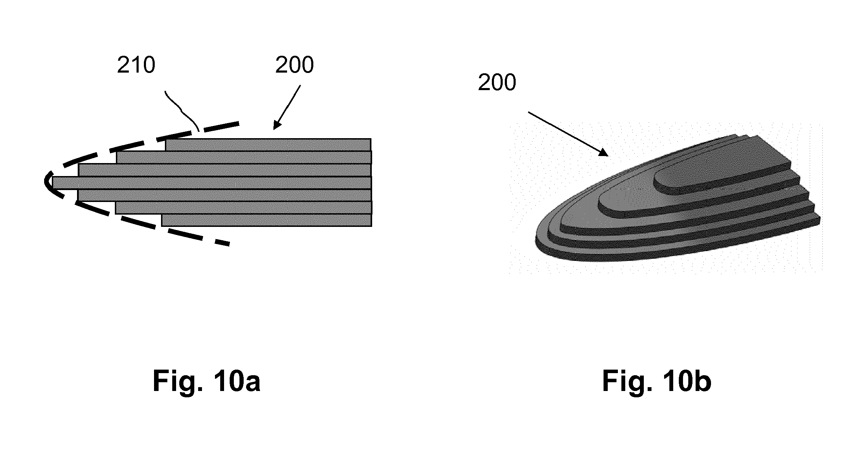

Figures 10a, 10b illustrate an embodiment where shaped electric circuit boards are stacked thus allowing the electric circuit to conform to unconventional shapes, e.g. an electric circuit board arrangement 200 having staggered edges, indicated by a broken line 210 in Figure 10a. The invention allows for new form factor designs while maintaining a high circuit density.

To summarize, the invention allows for simplification of processes for embedding components, simultaneous bulk or mass assembly of two or more circuit boards, top and bottom side soldering of two sided dies. Use can be made of the space inside a board to embed components. Miniaturization of the arrangement as well as low cost assembly methods is possible. The invention also has the ability to utilize unconventional volume shapes.

## Claims

1. A method for mounting a component (50) to an electric circuit board (10), comprising the steps:
- providing at least one cavity (40) in the electric circuit board (10, 100);
- arranging the component (50) in the cavity (40);
- generating in the at least one cavity (40) mechanical and/or electrical connections simultaneously to at least two locations of the component (50).

2. The method according to claim 1, further arranging the cavity (40) adjacent at least one through-hole (20) or via in the electric circuit board (10).

3. The method according to claim 1 or claim 2, wherein the at least one through-hole (20) or via is provided with an electrically conducting plating (22) and the component (50) is mechanically and/or electrically connected to the plating (22).

4. The method according to any of the preceding claims , wherein the component (50) is coupled to the at least one circuit board (10) by at least one of reflow soldering, solder wave, selective solder, solder fountain.

5. The method according to any of the preceding claims, wherein the component (50) is arranged flush with at least one surface (16) of the at least one electric circuit board (10) or with a surface (24) of a plating arranged at the at least one electric circuit board (10).

6. An electric circuit board (10) comprising
- at least one cavity (40) arranged in the electric circuit board (10);
- at least one component (50) accommodated in the at least one cavity (40);
- mechanical and/or electrical connections at at least two locations of the component (50) generated simultaneously in the at least one cavity (40).

7. The electric circuit board according to claim 6, wherein the at least one component (50) is an electric device comprising one or more terminal pads (52, 54, 56, 58).

8. The electric circuit board according to claim 6 or claim 7, wherein the at least one component (50) is arranged flush with respect to a surface (16) of the electric circuit board (10) or is arranged flush with respect to a surface (24) of a plating (22) on the electric circuit board (10).

9. The electric circuit board according to any one of claims 6 to 8, wherein the at least one component (50) is arranged underneath an electric component (150) arranged on the surface (16) of the electric circuit board (10)

10. A method for making an electric circuit board arrangement (200) comprising at least one electric circuit board (300, 400, 500), comprising the steps:
- providing at least one cavity (340, 440, 540) in the at least one electric circuit board (300, 400, 500);
- arranging the component (50) in the at least one cavity (340, 440) being mechanically and/or electrically connectable by contact in the at least one cavity (340, 440) and
- stacking one or more electric circuit boards (400, 500) on top of the at least one electric circuit board (300) and coupling the electric circuit boards (300, 400, 500) by solderable terminal pads (52, 54) of the component (50).

11. The method according to claim 10, further arranging the cavity (340, 440) adjacent at least one through-hole (320, 420) or via in the electric circuit board (300, 400, 500).

12. The method according to claim 10 or claim 11, wherein the at least one through-hole (320, 420) or via is provided with an electrical conducting plating and the component (50) is mechanically and/or electrically connected to the plating.

13. The method according to any one of claims 10 to 12, wherein the electric circuit boards (300, 400, 500) are interconnected by reflow soldering.

14. An electric circuit board arrangement (200) comprising at least one electric circuit board (300, 400, 500), comprising
- at least one cavity (340, 440, 540) in the at least one electric circuit board (300, 400, 500);
- at least one component (50) arranged in the at least one cavity (340, 440) and mechanically and/or electrically connectable by contacts (60) in the at least one cavity (340, 440); and
- one or more electric circuit boards (400, 500) stacked on top of the at least one electric circuit board (300) and coupled with adjacent electric circuit boards (400) by solderable connections.

15. The arrangement according to claim 14, wherein the one or more electric circuit boards (300, 400) are coupled by solderable terminations (52, 54) of the component (50).
